# EUROPÄISCHE PATENTSCHRIFT

(11) **EP 0 404 760 B1**
(45) Veröffentlichungstag und Bekanntmachung des Hinweises auf die Patenterteilung: **23.02.1994**
(21) Anmeldenummer: 88902139.0
(22) Anmeldetag: 05.03.1988
(51) Int. Cl.: H01L 21/50, H01L 23/04

(54) **HALBLEITERBAUELEMENT MIT ZWEI ANSCHLÜSSEN, DESSEN HERSTELLVERFAHREN UND AUSFÜHRUNGSVORRICHTUNG DAFÜR**
SEMICONDUCTOR COMPONENT WITH TWO CONNECTIONS AND PROCESS AND DEVICE FOR MANUFACTURING IT
COMPOSANT SEMI-CONDUCTEUR A DEUX CONNEXIONS, ET PROCEDE ET DISPOSITIF POUR SA FABRICATION

(43) Veröffentlichungstag der Anmeldung: 02.01.1991
(73) Patentinhaber: Deutsche ITT Industries GmbH, 79108 Freiburg (DE)
(72) Erfinder: MICIC, Ljubomir, D-7800 Freiburg i.Br. (DE); GÄRTLEIN, Günter, D-7838 Freiamt (DE); SCHMITT, Eberhard, D-7800 Freiburg i.Br. (DE); MÜLLER, Alex, D-7800 Freiburg i.Br. (DE); SENG, Egon, D-7832 Kenzingen-Hecklingen (DE); SPINDLER, Siegfried, D-7808 Waldkirch (DE)
(86) Internationale Anmeldenummer: EP8800173
(87) Internationale Veröffentlichungsnummer: WO8908325

(56) Entgegenhaltungen:
- EP-A- 0 154 562
- FR-A- 1 115 824
- LU-A- 67 455
- US-A- 3 127 285
- US-A- 3 165 812
- ELECTRONICS, Bd. 59, Nr. 29, August 1986, (NEW York, US); J. Gosch: "Implosion packaging speeds diode production"

## Beschreibung

Eine der heute weit verbreiteten Kunststoffumhüllungen für Halbleiterbauelemente mit zwei Zuleitungen, z.B. Dioden - insbesondere Gleichrichter (Ströme von bis zu ca. 1 A und Sperrspannungen von ca. 100 V bis 2 kv) -, Varistoren oder Thermistoren ist kreiszylindrisch mit in derselben Achse austretenden Zuleitungen. Der Halbleiterkörper und die inneren Enden von dessen Zuleitungen sind in den Kunststoff, z.B. ein Thermoplast oder ein Duroplast, hermetisch eingebettet und somit gegen mechanische Beanspruchung und chemische Einflüsse, z.B. das Eindringen vor Feuchtigkeit geschützt.

Bei der Herstellung derartiger Halbleiterbauelemente mit Kunststoffumhüllung ist einerseits der Ausgangspunkt für den Halbleiterkörper eine Halbleiterplatte, an der mehrere 100 bis mehrere 1000 identische Halbleiterkörper hergestellt werden, und andererseits wird für die Zuleitungen des Halbleiterbauelements von sogenannten Kopfdrähten, also Zuleitungen, die an ihrem einen Ende eine, z.B. angestauchte, Verdickung, den "Kopf", aufweisen, ausgegangen. Zwischen den beiden Köpfen wird der Halbleiterkörper, z.B. durch Löten, befestigt.

Zur Erzielung eines großen Stückzahldurchsatzes wird eine Vielzahl unverzinnter Kopfdrähte in Magazine eingefüllt, auf den Köpfen jeweils ein Halbleiterkörper positioniert und die Köpfe von anderen in ein weiteres Magazin eingebrachten Kopfdrähten auf die Halbleiterkörper gesetzt. In einem Ofen werden dann die Halbleiterkörper mit ihren jeweils zwei zugehörigen Kopfdrähten durch Löten verbunden. Wenn das fertige Halbleiterbauelement eine hohe Sperrspannung haben soll, werden die verlöteten Halbleiterkörper geätzt und mit einem geeigneten Kunststoff abgedeckt.

Anschließend werden die schon soweit gefertigen Halbleiterbauelemente in Preßformen umgefüllt und darin mit dem Kunststoff umpreßt oder umspritzt. Die Zuleitungen der nunmehr vorliegenden einzelnen Halbleiterbauelemente werden erst jetzt verzinnt, was wegen des hohen möglichen Durchsatzes durch Trommelverzinnen geschieht. Danach müssen jedoch die dabei verbogenen Zuleitungen in entsprechenden Richtvorrichtungen wieder axial ausgerichtet werden. Erst danach werden sie gemessen, gegurtet und beschriftet.

Derzeitige Richtvorrichtungen haben einen stündlichen Durchsatz von ca. 20.000 Halbleiterbauelementen. Das ist im Hinblick auf eine kostengünstige Massenfertigung inzwischen erheblich zu wenig, da die Einzelpreise für Halbleiterbauelemente wie schon immer weiter sinken.

Obwohl das geschilderte Herstellungsverfahren ein bewährtes Massenverfahren ist, besteht das Bestreben, davon, insbesondere unter dem Gesichtspunkt einer weiteren Reduzierung der Herstellungskosten, abzugehen und Halbleiterbauelemente zu schaffen, die noch kostengünstiger hergestellt werden können.

Aus der US-PS 31 27 285 ist eine Diode bekannt, deren Halbleiterkristall zwischen zwei bandförmigen axial ausgerichteten Zuleitungen angeordnet ist, wobei die aktiven Zonen des Halbleiterkristalls jeweils mit einer der Zuleitungen verbunden sind. Eine schützende, hermetisch dichte Kunststoffbeschichtung umgibt den Kristall und erstreckt sich über den Ansatz der Zuleitungen.

Die EP-PS 0 154 562 offenbart wiederum eine Gleichrichteranordnung aus vier Halbleiterkristallen (Dioden), die stapelförmig zwischen koaxialen Zuleitungen angeordnet sind. Letztere sind an ihren Enden, zwischen denen die Dioden befestigt sind, abgekröpft und paddelförmig verformt.

Die Aufgabe der in den Ansprüchen gekennzeichneten Erfindung in ihren verschiedenen Patentkategorien besteht somit darin, ein Halbleiterbauelement anzugeben, das zwar eine Kunststoffumhüllung hat, die jedoch im Hinblick auf die Kostenreduzierung anders als die bisher weit verbreiteten Kunststoffumhüllungen aufgebaut ist. Dabei sollen auch die Zuleitungen von der bisherigen Art abweichend ausgebildet sein. Beim Verfahren soll der geschilderte Schritt des Ausrichtens der Zuleitungen entfallen. Auch das Verzinnen nach dem Umpressen oder Umspritzen soll entfallen können. Ferner liegt es im Rahmen der Aufgabe der Erfindung, eine Vorrichtung anzugeben, mit der ein insgesamt höherer stündlicher Durchsatz an herzustellenden Halbleiterbauelementen erzielbar ist.

Einer der Grundgedanken der Erfindung besteht darin, das bei der bisherigen Herstellungsart erst während des Umspritzens oder Umpressens des Halbleiterkörpers entstehende Kunststoffgehäuse für sich in einem eigenen Herstellvorgang als becherförmiges Gehäuse, im folgenden Becher genannt, herzustellen, womit z.B. der Vorteil einer größeren Freiheit in der Wahl des zu verwendenden Ausgangskunststoffs sowie der beim Umpressen oder Umspritzen anzuwendenden Temperaturen und Drücke verbunden ist, und den Becher mit einer Kunststoffmasse, z.B. einem Gießharz, nach dem Einbringen des Halbleiterkörpers zu füllen.

Ein weiterer Grundgedanke der Erfindung ist der gegenüber bisher völlig andere Ausgangspunkt für die Herstellung der Zuleitungen, nämlich diese von einem von einer Drahtrolle ablaufenden Draht zu gewinnen, diesen einen Großteil der Fertigungsstufen Zusammenhängend durchlaufen zu lassen und erst nach Ausbildung der Kunststoffumhüllung, also der Anbringung der Becher, in die einzelnen Halbleiterbauelemente aufzutrennen.

Als Vorteile der Erfindung sind zu nennen: es kann ein billiger Kunststoff für die Becher benutzt werden. Die Fressen zur Herstellung der becherförmigen Gehäuse können einfacher aufgebaut und somit kleiner als die bisherigen Pressen sein. Die geschilderte Richtvorrichtung ist überflüssig geworden, und somit ist ein höherer stündlicher Durchsatz möglich. Es ist keine Polaritätsfeststellvorrichtung mit nachfolgender Wendevorrichtung mehr erforderlich, so daß die Halbleiterbauelemente gleichsinnig ohne die letztere gegurtet werden können. Die Halbleiterkörper lassen sich nämlich schon von der Halbleiterplatte aus mit vorgegebener Polarität zwischen die Zuleitungen bringen, und die Gleichsinnigkeit dieser Polarität läßt sich bis zum Gurten beibehalten.

Die Erfindung wird nun anhand der Figuren der Zeichnung näher erläutert.
Fig. 1 zeigt perspektivisch ein bevorzugtes Ausführungsbeispiel des erfindungsgemäßen Halbleiterbauelements,
Fig. 2 zeigt den Werdegang eines bevorzugten Ausführungsbeispiels der Erfindung, und
Fig. 3 zeigt als Ausführungsbeispiel stark schematisiert die verschiedenen Stationen der erfindungsgemäßen Vorrichtung.

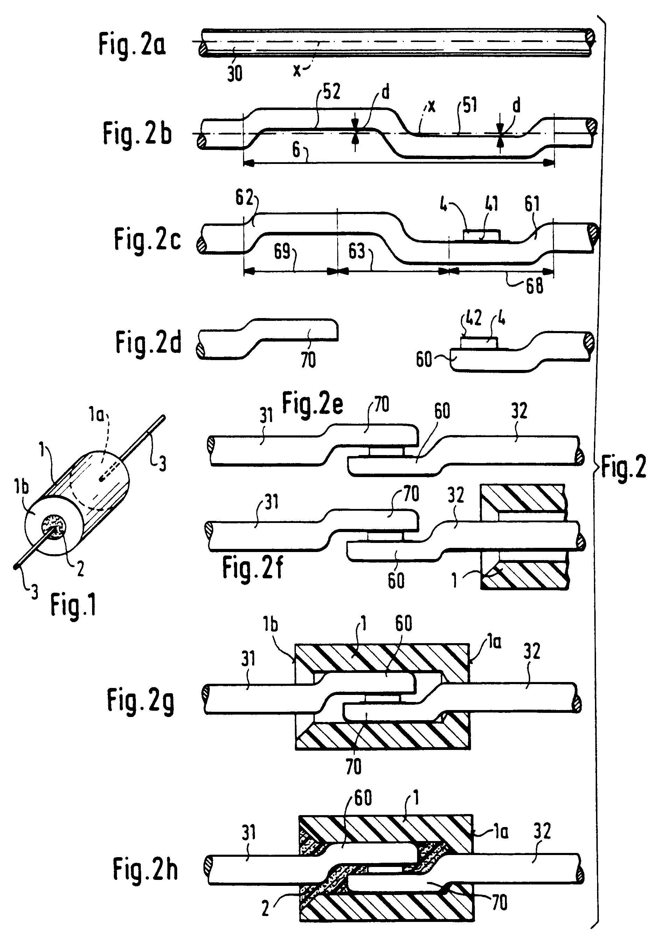

In der perspektivischen Darstellung der Fig. 1 ist als Ausführungsbeispiel ein fertiges Halbleiterbauelement entsprechend der Erfindung gezeigt, das das kreiszylindriche, becherförmige Gehäuse 1, im folgenden kurz Becher genannt, sowie die beiden Zuleitungen 3 umfaßt, wobei an der Vorderfläche 1b des Bechers 1 das eingefüllte und ausgehärtete Gießharz 2 zu sehen ist. Die in Fig. 1 hintere Zuleitung 3 ist durch den Boden 1a des Bechers 1 gesteckt, aus dem sie herausragt.

Die acht Teilfiguren der Fig. 2 zeigen aufeinanderfolgende Stadien des Werdegangs eines bevorzugten Ausführungsbeispiels der Erfindung, nämlich eines Halbleiterbauelements mit kreiszylindrischen Zuleitungen. Dieses Ausführungsbeispiel eignet sich besonders gut für die eingangs erwähnten Gleichrichter mit den dort angegebenen elektrischen Kennwerten. Das in Fig. 2a gezeigte Stück des Drahtes 30 ist dasjenige, an dem die weiteren Schritte vorgenommen werden, damit aus ihm die beiden zur Befestigung des Halbleiterkörpers erforderlichen inneren Zuleitungsenden entstehen können.

In Fig. 2b ist gezeigt, wie mittels eines entsprechenden Werkzeugs am Draht 30 nach Fig. 2a der Kröpfungsabschnitt 6 erzeugt ist, der in bevorzugter Ausgestaltung der Erfindung z-förmig ist. Es ist jedoch auch ohne weiteres möglich, eine einfache Kröpfung vorzunehmen, so daß sich die Kröpfung vom linken Anfang bis zum rechten Ende des Kröpfungsabschnitts 6 gleichmäßig fortsetzt, das Drahtstück also etwa wannenförmig ausgebildet ist.

Zugleich mit dem Anbringen der Kröpfung ist der Draht 30 im Angriffsbereich des Kröpfwerkzeugs flächig verformt worden, so daß sich ebene Auflageflächen 51, 52 zum Aufbringen eines Halbleiterkörpers ergeben. Der Abstand d zwischen der Drahtachse x und den Auflageflächen 51, 52 soll etwa gleich der halben Dicke des Halbleiterkörpers sein,

In Fig. 2c ist gezeigt, wie der Halbleiterkörper 4 in der Nähe der Kröpfungsstelle 61 mit seiner einen Hauptfläche 41 auf die eine Auflagefläche 51 (Fig. 2b) aufgesetzt ist. In Fig. 2d ist gezeigt, daß der Mittelteil 63 herausgeschnitten ist, so daß sich die inneren Zuleitungsenden 60, 70 ergeben. In Fig. 2e ist der Zustand gezeigt, nachdem das durch das Wegschneiden des Mittelteils 63 entstandene noch freie Zuleitungsende 70 über den Halbleiterkörper 4 geschoben und dort mit der anderen Hauptfläche 42 des Halbleiterkörpers 4 verbunden wurde.

Nach Fig. 2f wird nun auf die Zuleitung 32 der Becher 1 aufgeschoben, bis er die in Fig. 2g gezeigte Position einnimmt, d.h. die inneren Zuleitungsenden 60, 70 vollständig im Becher aufgenommen sind und aus diesem die Zuleitungen 31, 32 axial herausragen. Die Becherinnenabmessungen und die Abmessungen der Zuleitungsenden 60, 70 sind so aneinander anzupassen, daß die Kröpfungsstellen 61, 62 (Fig. 2c) vollständig innerhalb des Bechers 1 liegen. Ferner ist die Innenweite des Bechers 1 an das Außenmaß der inneren Zuleitungsenden 60, 70 mit dazwischenliegendem Halbleiterkörper 4 oder auch nur die Bohrung im Boden 1a an den Durchmesser der Zuleitung 32 so anzupassen, daß sich ein leichter Preßsitz ergibt und der Becher 1 somit bei den weiteren Verfahrensschritten nicht abfällt.

Die Fig. 2h zeigt schließlich das eingefüllte Gießharz 2, das den Hohlraum des Bechers 1 vollständig ausfüllt und somit auch den Halbleiterkörper 4 hermetisch abdichtet.

Anstelle eines zylindrischen Drahtes kann auch ein Draht mit quadratischem oder rechteckigem Querschnitt verwendet werden. In diesem Fall ist das Anbringen der Auflageflächen 51, 52 selbstverständlich nicht erforderlich.

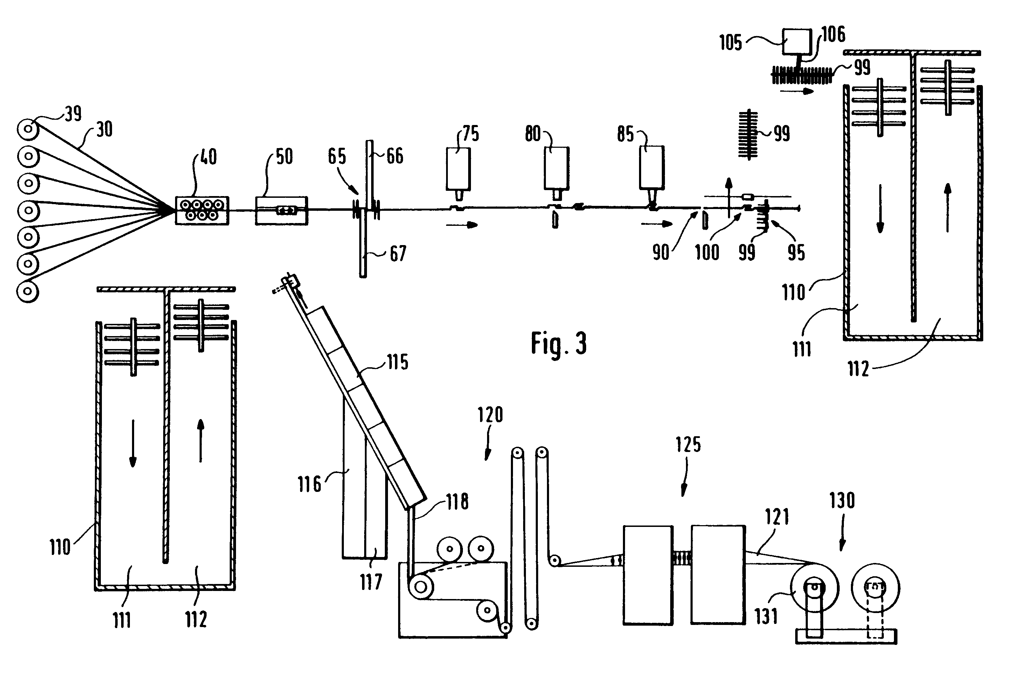

Der Verfahrensablauf bei der Herstellung einer Vielzahl von verkaufsfertigen Halbleiterbauelementen ist wie folgt: die Zuleitungen 31, 32 stammen von der Drahtrolle 39 (Fig. 3), wobei dieser Draht nach einer bevorzugten Ausgestaltung der Erfindung bereits verzinnt ist - er kann aber auch erst nach dem Ablaufen von der Rolle 39 verzinnt werden; nach Ausrichtung und/oder Streckung, so daß ein geradegerichteter Draht entsteht, werden gleichmäßig beabstandete Kröpfungsabschnitte 6 angebracht, die auch die im Ausführungsbeispiel der Fig. 2 gezeigte bevorzugte z-förmige Doppelkröpfung aufweisen können; das Rastermaß der Kröpfungsabschnitte ergibt sich aus der gewünschten Länge der Zuleitungen am fertigen Halbleiterbauelement unter Berücksichtigung der Länge des herausgeschnittenen Mittelsteils 63; falls es sich beim Draht 30 um einen kreiszylindrischen handelt, wird gleichzeitig mit der Kröpfung eine flächige Verformung des Zylindermantels im Kröpfungsabschnitt vorgenommen, so daß sich eine ebene Auflagefläche für den Halbleiterkörper ergibt; dieser wird nun mit seiner einen Hauptfläche 41 auf dem Kröpfungsabschnitt in der Nähe der einen Kröpfungsstelle 61 befestigt; der Mittelteil 63 wird herausgeschnitten, wobei es im Falle der erwähnten einfachen Kröpfung auch genügt, den Kröpfungsabschnitt 6 in der Mitte einfach zu durchtrennen; der dadurch entstandene noch freie Kröpfungsabschnitt wird in letzterem Fall dadurch über die andere Hauptfläche 42 des Halbleiterkörpers 4 geschoben, daß die Zuleitung 32 mit dem Halbleiterkörper 4 axial um 180° gedreht wird und dann der freie Kröpfungsabschnitt darübergeschoben und die Hauptfläche 42 daran befestigt wird; diese Befestigung geschieht bei einer bevorzugten Verfahrensvariante durch Löten mittels einer für jeden Halbleiterkörper eigenen im Wasserstoffüberschuß brennenden Wasserstoffflamme entweder für beide Hauptflächen 41, 42 getrennt nacheinander oder in einem einzigen gleichzeitigen Verfahrensschritt miteinander, wodurch kein Flußmittel für das Verlöten der metallisierten Hauptflächen 41, 42 des Halbleiterkörpers 4 mit dem verzinnten Draht 30 erforderlich ist - anstatt derart zu löten, ist es auch möglich, die Drähte auf einer Heizplatte zum Löten zu erhitzen oder anstatt des Lötens einen Leitkleber zu verwenden; nunmehr wird einer der Becher 1 auf die Zuleitungsenden 60, 70 mit dem Halbleiterkörper 4 aufgesteckt und dann die erforderliche Menge an Gießharz 2 eingefüllt und dieses anschließend ausgehärtet; schließlich werden die nunmehr mechanisch fertigen Halbleiterbauelemente gemessen und die in einem vorgegebenen Gutbereich liegenden gegurtet und anschließend beschriftet, während die schlechten vernichtet und die anders als guten ebenfalls gegurtet und anders beschriftet werden.

In Fig. 3 ist stark schematisiert der Aufbau einer erfindungsgemäßen Vorrichtung zur Herstellung der Halbleiterbauelemente nach der Erfindung entsprechend dem geschilderten Verfahren dargestellt. Bei der Herstellung wird von den Drahtrollen 39 ausgegangen, von denen die Drähte 30 zu der Ausrichtstation 40 und der Streckstation 50 laufen, die jeden der Drähte 30 geraderichten. Dieses Ausrichten und Strecken geschieht während des gesamten Herstellvorgangs der Halbleiterbauelemente nur einmal, sozusagen zu Beginn des Verfahrens, und die weiteren Stationen und Verfahrensschritte sind so ausgebildet bzw. werden so vorgenommen, daß die Geradheit der später zu den Zuleitungen werdenden Drähte nicht mehr verändert wird. Die Ausricht- und Streckstationen 40, 50 enthalten für jeden der Drähte 30 eine entsprechende Teilstation, was in Fig. 3 nicht gezeigt ist; das Zusammenlaufen der links in Fig. 3 gezeigten sieben Drähte 30 am Eingang der Ausrichtstation 40 soll lediglich veranschaulichen, daß alle Drähte in die Station 40 einlaufen.

Nach Verlassen der Streckstation 50 gelangen die Drähte in die Kröpfstation 65, von der im Ausführungsbeispiel der Fig. 3 die beiden Kröpfstempel 66, 67 gezeigt sind, die, wenn die Drähte 30 kreiszylindrisch sind, zugleich durch entsprechende flächige Ausbildung an ihren mit dem Draht in Berührung kommenden Enden die Auflageflächen 51, 52 (Fig. 2b) anformen. Durch die beiden Kröpfstempel 66, 67 wird die in Fig. 2b gezeigte Doppelkröpfung am Draht 30 angebracht. Wenn nur die oben bereits erläuterte einfache Kröpfung beabsichtigt ist, kann auf einen der beiden Kröpfstempel 66, 67 verzichtet werden.

Selbstverständlich enthält die Kröpfstation 65 soviele Kröpfstempel bzw. Kröpfstempelpaare, wie Drähte gleichzeitig bearbeitet werden müssen, also z.B. die erwähnten ca. 100. Anstelle der Kröpfstempel kann auch eine entsprechende Walzvorrichtung für alle Drähte eingesetzt werden.

Nach Verlassen der Kröpfstation 65 gelangt der nunmehr gekröpfte Draht zur Halbleiterkörper-Aufbringstation 75, in der auf den Kröpfungsabschnitt bzw. einen der Kröpfungsabschnitte, wenn eine Doppelkröpfung angebracht wurde, ein Halbleiterkörper aufgesetzt wird. Dies geschieht auch hier wieder gleichzeitig für alle Drähte, d.h. bei den erwähnten ca. 100 Drähten wird gleichzeitig auf jeden dieser Drähte ein Halbleiterkörper aufgesetzt, und zwar derart, daß bei allen Halbleiterkörpern diesselbe Halbleiterzone mit dem jeweiligen Draht in Verbindung gebracht wird, also z.B. die N-Zone. Bei den erwähnten verzinnten Drähten ist es zweckmäßig, die beiden Halbleiterzonen der Halbleiterkörper schon an der erwähnten Halbleiterplatte mit einer das Verlöten mit dem Zinnüberzug ermöglichenden Metallschicht zu versehen, z.B. zu bedampfen etc. , das mit dem verzinnten Draht eine Lötverbindung eingeht. Hierfür geeignete Metalle sind beispielsweise Gold, Palladium oder Silber.

Das gleichzeitige Aufbringen der ca. 100 Halbleiterkörper kann beispielsweise so ablaufen, daß die wie üblich durch Sägen in die einzelnen Halbleiterkörper vorzerteilte Halbleiterplatte unter Beibehaltung der Orientierung der Halbleiterkörper entgültig zerteilt wird und die einzelnen Halbleiterkörper zunächst in ein Magazin übernommen werden, von dem aus sie, z.B. mittels Saugpipetten, auf eine Ausrichtplatte gelegt werden, wo sie bezüglich ihrer Seitenkanten parallel zueinander ausgerichtet und auch in genau denselben Abstand voneinander gebracht werden. Dieser Vorgang läßt sich mittels einer optischen Überwachung leicht automatisieren. Die ausgerichteten Halbleiterkörper werden durch einen weiteren Satz von Saugpipetten nunmehr auf die Auflageflächen der Drähte aufgesetzt.

Auf die Aufbringstation 75 folgt die erste Schneid- und Vorschubstation 80, in der der Kröpfungsabschnitt 6 (Fig. 2b) durchtrennt oder nach Fig. 2c der Mittelteil 63 aus dem gekröpften Draht herausgeschnitten wird. Nach dem Durchtrennen wird der so entstandene, "linke" freie Kröpfungsabschnitt 70 über den Halbleiterkörper 4 geschoben, indem der Draht eine entsprechend bemessene Vorwärtsbewegung ausführt, während der "rechte" Draht festgehalten wird.

Auf die Station 80 folgt die Halbleiterkörper-Befestigungsstation 85, in der die beiden Hauptflächen 41, 42 des Halbleiterkörpers 4 (Fig. 2c, d) mit dem verzinnten Draht verlötet werden. Dies geschieht z.B. durch die bereits oben erwähnten einzelnen Wasserstoffflämmchen, die in Wasserstoffüberschuß arbeiten, so daß durch den überschüssigen Wasserstoff das Zinn reduziert wird und kein Flußmittel erforderlich ist, dessen Rückstände in einem nachfolgenden Waschvorgang entfernt werden müßten. Somit ergibt sich ein weiterer Vorteil der Erfindung, daß nämlich während des gesamten Anbringens der Zuleitungen keine chemischen Prozeßschritte erforderlich sind.

Auf die Station 85 folgt die zweite Schneidstation 90, in der die z.B. 100 Drähte gleichzeitig durchtrennt werden. An dieser Stelle erfolgt die Vereinzelung in eine Vorstufe der fertigen Halbleiterbauelemente, nämlich in diejenige Fertigungsstufe, in der die Becher 1 auf die inneren Zuleitungsenden 60, 70 (Fig. 2e bis h) aufgeschoben und mit Gießharz verfüllt werden.

Das Aufschieben der Becher erfolgt in der Becheraufbringstation 100, die zuvor in der Einfüllstation 95, z.B. hundertweise in das Magazin 99 eingesetzt worden sind. Durch dieses Magazin gehaltert, werden in die Becher die jeweiligen Anordnungen 32, 60, 70, 31 aufgrund des Vorschubs der Drähte entsprechend den Fig. 2f bis h eingeschoben. Zum besseren Einführen in den Becher 60 ist dieser an seiner Öffnung 1b angefast. Hinter der zweiten Schneidstation 90 ändert sich die Transportrichtung um 90° und das jeweilige Magazin 99 wird, nunmehr mit den umbecherten Halbleiterbauelementen zur Kunstoffmasse-Einfüllstation 105 transportiert, vor der eine weitere Umlenkung der Transportrichtung um 90° derart erfolgt, daß die Öffnung 1a der Becher 1 unter den Einfüllstutzen der Einfüllstation 105 angeordnet ist. Deren Anzahl ist gleich der Anzahl der Becher pro Magazin, also beispielsweise wiederum die erwähnten ca. 100; von ihnen ist jedoch aus zeichnerischen Vereinfachungsgründen nur der eine Anschlußstutzen 106 in Fig. 3 gezeigt.

Die nunmehr fast schon fertiggestellten Halbleiterbauelemente gelangen mit dem Magazin 99 in die Aushärtestation 110, die aus einem Erwärmungsteil 111 und einem Abkühlungsteil 112 besteht. Aus dessen Auslaß werden die Magazine 99 entnommen und dann in die Einfüllöffnung der Meßstation 115 parallel entleert. In Fig. 3 ist aufgrund der Aufteilung auf zwei Hälften der Figur die Aushärtestation 110 sowohl in der oberen als auch in der unteren Hälfte gezeigt, was lediglich zur Verständniserleichterung dienen soll, jedoch nicht bedeutet, daß die Aushärtestation realiter zweimal vorhanden wäre.

Der in Fig. 3 gezeigte beispielsweise Aufbau der Meß- und Sortierstation 115 mißt und sortiert die ca. 100 Halbleiterbauelemente gleichzeitig, jedoch nur in drei Gruppen und hat somit lediglich den Schlechtbehälter 116 und den Behälter 117 für Halbleiterbauelemente, die andere Eigenschaften als die eingestellte Gutbedingung aufweisen, sowie den Ausgang 118 für die im Gutbereich liegenden Bauelemente (= prime type devices). Nach dem Aussortieren der schlechten und der anderweitig guten Halbleiterbauelemente werden die guten, die bis hierher parallel geführt sind, seriell, also zeitlich nacheinander zur Gurtungsstation 120 und von da zur Beschriftungsstation 125 weitergeführt. Der Gurt 121 mit den beschrifteteten Bauelementen wird schließlich in der Aufrollstation 130 zu den entsprechenden Rollen mit den verkaufsfertigen Halbleiterbauelementen aufgewickelt.

## Patentansprüche

1. Halbleiterbauelement, mit zwei koaxialen Zuleitungen (3) und mit einem zwischen einander zugekehrten Seiten der inneren Enden (60, 70) der Zuleitungen (3) befestigten, vorgefertigten Halbleiterkörper (4), gekennzeichnet durch ein aus Kunststoff vorgefertigtes becherförmiges, vorzugsweise kreiszylindrisches, Gehäuse (1), das mit einer Kunststoffmasse, vorzugsweise einem Gießharz (2), gefüllt und durch dessen Boden (1a) die eine Zuleitung gesteckt ist, wobei die inneren Enden (60, 70) der Zuleitungen (3) in das Gehäuse (1) eingesteckt sind.

2. Halbleiterbauelement nach Anspruch 1 mit mindestens einer innerhalb des Gehäuses (1) gekröpften, drahtförmigen Zuleitung (31; 32).

3. Halbleiterbauelement nach Anspruch 1 oder 2 mit Zuleitungen (31, 32), die an ihrem jeweiligen inneren Ende (60, 70) auf der mit dem Halbleiterkörper (4) verbundenen Seite zu einer Auflagefläche (51, 52) für diesen verformt sind.

4. Verfahren zum Herstellen einer Vielzahl von verkaufsfertigen Halbleiterbauelementen nach den Ansprüchen 1 bis 3, bei dem
a) Zuleitungen (31, 32) von einer Drahtrolle (39) stammen, deren, insbesondere verzinnter, Draht nach Ausrichtung und/oder Streckung mit gleichmäßig beabstandeten Kröpfungsabschnitten (6) und zugleich mit Auflageflächen (51, 52) versehen wird,
b) eine Hauptfläche (41) eines Halbleiterkörpers (4) auf der angeformten Auflagefläche (51) in der Nähe einer Kröpfungsstelle (61) befestigt wird,
c) der Kröpfungsabschnitt (6) etwa in der Mitte durchtrennt und die Auflagefläche (52) des so entstehenden, noch freien Kröpfungsabschnitts über den Halbleiterkörper (4) geschoben und an dessen anderer Hauptfläche (42) befestigt wird,
d) in ein aus Kunststoff vorgefertigtes, becherförmiges Gehäuse (1) der Halbleiterkörper (4) mit den Zuleitungsenden (70, 60) eingesteckt und dann eine erforderliche Menge an Kunststoffmasse eingefüllt sowie anschließend dieses ausgehärtet wird und
e) die nunmehr mechanisch fertigen Halbleiterbauelemente gemessen und die in einem vorgegebenen Gutbereich liegenden gegurtet und anschließend beschriftet werden.

5. Verfahren nach Anspruch 4, bei dem durch Doppelkröpfung zwei aufeinanderfolgende Kröpfungsteilabschnitte (68, 69) erzeugt werden, deren Mittelteil (63) im Verfahrensschritt c) entfernt wird.

6. Verfahren nach den Ansprüchen 4 und 5, bei dem die Verfahrensschritte a) bis c) gleichzeitig an einer Vielzahl von Drähten, die von derselben Vielzahl an Drahtrollen stammen, insbesondere an ca. 100 Drähten, ablaufen und bei dem der Verfahrensschritt d) gleichzeitig mit derselben Anzahl an Gehäusen in einem einzigen Schritt vorgenommen wird.

7. Verfahren nach Anspruch 6, bei dem jeder Halbleiterkörper (4) derart durch Löten mittels einer eigenen im Wasserstoffüberschuß brennenden Wasserstoffflamme befestigt wird, daß entweder beide Hauptflächen (41, 42) gleichzeitig oder die eine Hauptfläche (41) in einem ersten Taktschritt und die andere Hauptfläche (42) in einem nachfolgenden Taktschritt verlötet werden.

8. Vorrichtung zur Durchführung des Verfahrens nach Anspruch 6 oder 7 mit folgenden in Transportrichtung nacheinander angeordneten Stationen:
- einer Ausricht- und/oder einer Streckstation (40, 50)
- einer Kröpfstation (65), die ggf. auch die flächigen Verformungen (51, 52) anbringt,
- einer Halbleiterkörper-Aufbringstation (75),
- einer ersten Schneid- und Vorschubstation (80),
- einer Halbleiterkörper-Aufbring- und Befestigungsstation (85)
- einer zweiten Schneidstation (90),
- einer Einfüllstation (95) für das becherförmige Gehäuse (1) in ein Magazin (99),
- einer Gehäuse aufbringstation (100),
- einer Kunststoffmasse-Einfüllstation (105),
- einer Aushärtestation (110),
- einer Meß- und Sortierstation (115),
- einer Gurtungstation (120),
- einer Beschriftungsstation (125) und
- einer Aufrollstation (130) für den Gurt (121) mit den verkaufsfertigen Halbleiterbauelementen.

9. Vorrichtung nach Anspruch 9, bei der sich die Transportrichtung hinter der zweiten Schneidstation um 90° ändert und ebenso wieder vor der Kunststoffmasse-Einfüllstation.

## Claims

1. A semiconductor device comprising two coaxial leads (3) and a prefabricated semiconductor die (4) attached between those sides of the inner ends (60, 70) of the leads (3) which face toward each other, characterized by a prefabricated, can-shaped, preferably circular-cylinder-shaped, plastic housing (1) which is filled with a plastic compound, preferably a cast resin (2), and through whose bottom (1a) passes one of the leads, with the inner ends (60, 70) of the leads (3) inserted in the housing (1).

2. A semiconductor device as claimed in claim 1, comprising at least one lead (31; 32) offset within the housing (1).

3. A semiconductor device as claimed in claim 1 or 2, comprising leads (31, 32) having their respective inner ends (60, 70) deformed, on the side connected with the semi conductor die (4), into mounting surfaces (51, 52) for the semiconductor die (4).

4. A method of manufacturing a plurality of ready-to-sell semiconductor devices as claimed in claims 1 to 3 wherein
a) leads (31, 32) stem from a spool of wire (39) whose, preferably tinned, wire, after being straightened and/or stretched, is provided with equally spaced offset portions (6) and, at the same time, with mounting surfaces (51, 52);
b) one major surface (41) of a semiconductor die (4) is attached to the mounting surfaces (51) near an offset point (61);
c) the offset portion (6) is divided approximately in the middle, and the mounting surface (52) of the resulting free offset portion is moved onto the semiconductor die (4) and attached to the other major surface (42) of the latter;
d) the semiconductor die (4) with the lead ends (60, 70) is inserted into a prefabricated, can-shaped plastic housing (1), and a necessary quantity of plastic compound is then filled in and subsequently cured, and
e) the now mechanically finished semiconductor devices are tested, and those lying in a predetermined "go" range are taped and subsequently lettered.

5. A method as claimed in claim 4 wherein by double offsetting, two successive offset portions (68, 69) are forced whose middle portion (63) is removed in step c).

6. A method as claimed in claims 4 and 5 wherein steps a) to c) are performed simultaneously on a plurality of wires stemming from the same plurality of spools, preferably on about 100 wires, and wherein step d) is performed simultaneously on the same number of housings in a single operation.

7. A method as claimed in claim 6 wherein by soldering with a hydrogen flame burning in an excess of hydrogen, either both major surfaces (41, 42) of each semiconductor die (4) are soldered simultaneously or one major surface (41) is soldered in a first cycle step and the other major surface (42) in a subsequent cycle step.

8. Apparatus for carrying out the method claimed in claim 6 or 7, comprising the following stations arranged in the direction of conveyance:
- a straightening station and/or a stretching station (40, 50),
- an offsetting station (65) which also forms the mounting surfaces (51, 52) if necessary,
- a die placement station (75),
- a first cutting and feed station (80),
- a die attachment station (85),
- a second cutting station (90),
- a station (95) for feeding the can-shaped housing (1) into a magazine (99),
- a housing-mounting station (100),
- a plastic-compound-filling station (105),
- a curing station (110),
- a testing and sorting station (115),
- a taping station (120),
a lettering station (125), and
- a reeling station (130) for the tape (121) equipped with the ready-to-sell semi conductor devices.

9. A apparatus as claimed in claim 8 wherein the direction of conveyance changes by 90° behind the second cutting station and in front of the plastic-compound-filling station.

## Revendications

1. Composant à semiconducteur, comprenant deux fils d'connexion (3), ayant un même axe, et un corps en semiconducteur (4) préfabriqué qui est fixé entre des côtés se faisant face des extrémités intérieures (60, 70) des fils d'connexion (3), caractérisé par un boîtier (1), préfabriqué en matière plastique et en forme de dé, de préférence de forme cylindrique à section circulaire, qui est rempli d'une masse de matière plastique, de préférence d'une résine de moulage (2) et à travers le fond (1a) duquel l'un des fils d'connexion est enfilé, d'une façon telle que les extrémités intérieures (60, 70) des fils d'connexion (3) sont emboîtées dans le boîtier (1).

2. Composant à semiconducteur suivant la revendication 1, comprenant au moins un fil d'connexion (31, 32) en forme de fil métallique qui est coudé à l'intérieur du boîtier (1).

3. Composant à semiconducteur suivant l'une des revendications 1 et 2, comprenant des fils de connexion (31, 32) qui, à leur extrémité intérieure respective (60, 70), sont déformés sur le côté relié au corps en semiconducteur (4), de façon à former une surface d'appui (51, 52) pour ce dernier.

4. Procédé de fabrication d'une multiplicité de composants à semiconducteur prêts à la vente, conformes aux revendications 1 à 3, selon lequel :
a) des fils de connexion (31, 32) proviennent d'une bobine de fil métallique (39) dont le fil, notamment étamé, après réorientation et/ou étirement, est pourvu de sections coudées (6) uniformément espacées et en même temps de surfaces d'appui (51, 52),
b) une surface principale (41) d'un corps en semiconducteur (4) est fixée sur la surface d'appui façonnée (51), au voisinage d'une partie coudée (61),
c) la section coudée (6) est sectionnée approximativement en son milieu et la surface d'appui (52) de la section coudée encore libre ainsi formée est déplacée au-dessus du corps en semiconducteur (4) et est fixée sur l'autre surface principale (42) de ce dernier,
d) le corps en semiconducteur (4), pourvu des extrémités (70, 60) des fils de connexion, est emboîté dans un boîtier (1) préfabriqué en matière plastique, en forme de dé, puis une quantité nécessaire de masse de matière plastique le remplit et est ensuite durcie et
e) les composants à semiconducteur, désormais à l'état fini sur le plan mécanique, sont mesurés et ceux qui appartiennent à un domaine préfixé de produit sont montés sur bande, puis marqués.

5. Procédé suivant la revendication 4, selon lequel, au moyen d'un double coudage, il est réalisé deux sections partielles coudées (68, 69) qui sont disposées l'une à la suite de l'autre et dont une partie centrale (63) est ôtée dans l'étape c) du procédé.

6. Procédé suivant l'une des revendications 4 et 5 selon lequel les étapes de procédé a) à c) se déroulent simultanément sur de multiples fils qui proviennent d'un même nombre de bobines de fil, notamment sur 100 fils environ, et selon lequel l'étape de procédé d) est exécutée simultanément avec un même nombre de boîtiers en une étape unique.

7. Procédé suivant la revendication 6, selon lequel chaque corps en semiconducteur (4) est fixé par soudage, au moyen d'un chalumeau à hydrogène qui lui est propre et brûle avec un excès d'hydrogène, d'une façon telle que sont soudées soit les deux surfaces principales (41, 42) en même temps, soit l'une (41) des surfaces principales dans un premier pas de l'étape et l'autre surface principale (42) dans un pas suivant de l'étape.

8. Appareil de mise en oeuvre du procédé suivant l'une des revendications 6 et 7, comportant les postes suivants, disposés l'un derrière l'autre suivant la direction de transport:
- un poste de réorientation (40) et/ou un poste d'étirement (50),
- un poste de coudage (65), qui réalise éventuellement aussi les déformations planes (51, 52),
- un poste (75) de mise en place du corps en semiconducteur,
- un premier poste de découpage et d'avance (80),
- un poste (85) de mise en place et de fixation du corps en semiconducteur,
- un second poste de découpage (90),
- un poste de chargement (95) pour charger le boîtier (1) en forme de dé dans un chargeur (99),
- un poste (100) de mise en place du boîtier,
- un poste (105) de remplissage à l'aide d'une masse de matière plastique,
- un poste de durcissement (110),
- un poste de mesure et de classement (115),
- un poste (120) de mise sur bande,
- un poste de marquage (125) et
- un poste (130) d'enroulement de la bande (121) comportant les composants à semiconducteur prêts à la vente.

9. Appareil suivant la revendication 9, dans lequel la direction de transport est modifiée de 90° en aval du second poste de découpage et une fois encore en amont du poste de remplissage à l'aide d'une masse de matière plastique.
